# EUROPEAN PATENT APPLICATION

(11) **EP 4 439 669 A1**
(43) Date of publication of application: **02.10.2024**
(21) Application number: 24159938.0
(22) Date of filing: 27.02.2024
(51) Int. Cl.: H01L 27/06, H01L 29/775, H01L 23/528

(54) **INTEGRATED CIRCUIT DEVICES INCLUDING A BACK SIDE POWER DISTRIBUTION NETWORK STRUCTURE AND METHODS OF FORMING THE SAME**

(30) Priority: 29.03.2023 US 202363492849 P; 24.08.2023 US 202318454832
(71) Applicant: Samsung Electronics Co., Ltd., Suwon-si, Gyeonggi-do 16677 (KR)
(72) Inventor: KIM, Tae Sun, San Jose, CA 95134 (US); HONG, Wonhyuk, San Jose, CA 95134 (US); LEE, Jongjin, San Jose, CA 95134 (US); SEO, Kang-Ill, San Jose, CA 95134 (US)
(74) Representative: Kuhnen & Wacker Patent- und Rechtsanwaltsbüro PartG mbB

(57) **Abstract**

Integrated circuit devices and methods of forming the same are provided. The integrated circuit devices include a backside power distribution network structure (BSPDNS), a logic device region (101) and a passive device region (102) on the BSPDNS, a backside insulating layer (114) including a first portion extending between the BSPDNS and the logic device region and a second portion extending between the BSPDNS and the passive device region, the passive device region including a semiconductor layer (118) that is in the backside insulating layer, and a dam (130) separating the first portion of the backside insulating layer from the semiconductor layer of the passive device region.

## Description

### BACKGROUND

The present disclosure generally relates to the field of integrated circuit devices and, more particularly, to integrated circuit devices including a backside power distribution network structure (BSPDNS).

Various structures of an integrated circuit device and methods of forming the same have been proposed to increase the integration density of the integrated circuit device. Specifically, an integrated circuit device including elements formed in a substrate or on a backside of the substrate has been proposed to simplify the middle-of-line (MOL) portion and/or the back-end-of-line (BEOL) portion of device fabrication.

### SUMMARY

An integrated circuit device according to some embodiments may include a backside power distribution network structure (BSPDNS), a logic device region and a passive device region on the B SPDNS, a backside insulating layer including a first portion extending between the BSPDNS and the logic device region and a second portion extending between the BSPDNS and the passive device region, the passive device region including a semiconductor layer that is in the backside insulating layer, and a dam separating the first portion of the backside insulating layer from the semiconductor layer of the passive device region.

An integrated circuit device according to some embodiments may include a backside power distribution network structure (BSPDNS), a first device region and a second device region on the BSPDNS, a backside insulating layer extending between the BSPDNS and the first device region and between the BSPDNS and the second device region, the second device region including a semiconductor layer that is in the backside insulating layer, and a dam that is at least partially in the backside insulating layer. The dam may extend between the backside insulating layer and a side surface of the semiconductor layer.

A method of forming an integrated circuit device according to some embodiments may include providing a substrate including a first portion in a first device region and a second portion in a second device region. Electric circuits may be provided on a first surface of the substrate. The method may also include forming a dam in the substrate between the first portion and the second portion of the substrate, the dam including a material different from that of the substrate, removing the first portion of the substrate, forming a backside insulating layer on a second surface of the second portion of the substrate, forming a first backside contact in the backside insulating layer and electrically connected to at least one of the electric circuits, and forming a backside power distribution network structure (BSPDNS) on the first backside contact.

### BRIEF DESCRIPTION OF THE DRAWINGS

FIG. 1 is a plan view of an integrated circuit device according to some embodiments.
FIGS. 2 and 3 are cross-sectional views of an integrated circuit device taken along the line A-A' in FIG. 1 according to some embodiments.
FIG. 4 is a flow chart of a method of forming an integrated circuit device according to some embodiments.
FIGS. 5 through 12 are cross-sectional views illustrating a method of forming an integrated circuit device according to some embodiments.

### DETAILED DESCRIPTION

According to some embodiments, an integrated circuit device may include a dam that protects a portion of a substrate included in a second device region while removing a portion of the substrate included in a first device region. The dam formed between a first device region and a second device region may also prevent or mitigate an etch material from spreading to the second device region during formation of a backside power distribution network structure (BSPDNS). A backside insulating layer may be formed between the BSPDNS and the first device region and between the BSPDNS and the second device region, thereby alleviating a step difference between the first device region and the second device region during formation of the BSPDNS. Backside contacts may be electrically connected between the first device region and the BSPDNS and between the second device region and the BSPDNS, thereby reducing a resistance of the integrated circuit device.

Example embodiments will be described in greater detail with reference to the attached figures.

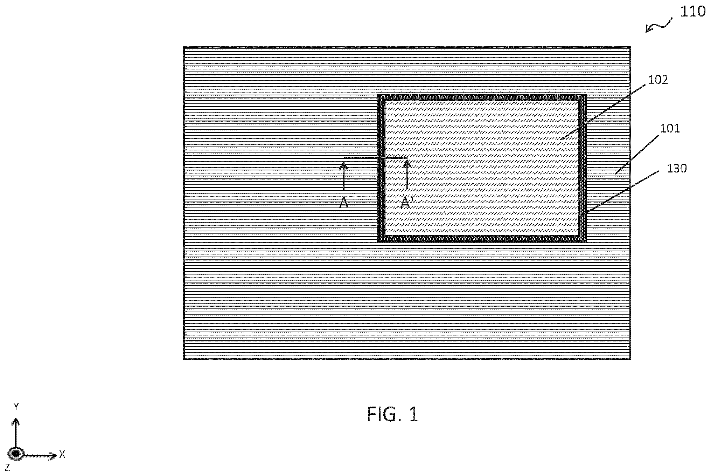

FIG. 1 is a plan view of an integrated circuit device 110 according to some embodiments. Referring to FIG. 1, the integrated circuit device 110 may include a first device region 101 (also referred to as a logic device region) and a second device region 102 (also referred to as a passive device region). In some embodiments, the first device region 101 may include one or more logic device(s) such as a Central Processing Unit (CPU), a Graphics Processing Unit (GPU), and/or a general logic circuit. In some embodiments, the second device region 102 may include one or more passive device(s) including, for example, one or more passive elements such as a resistor, a capacitor, an inductor, a transformer, a diode, and/or the like.

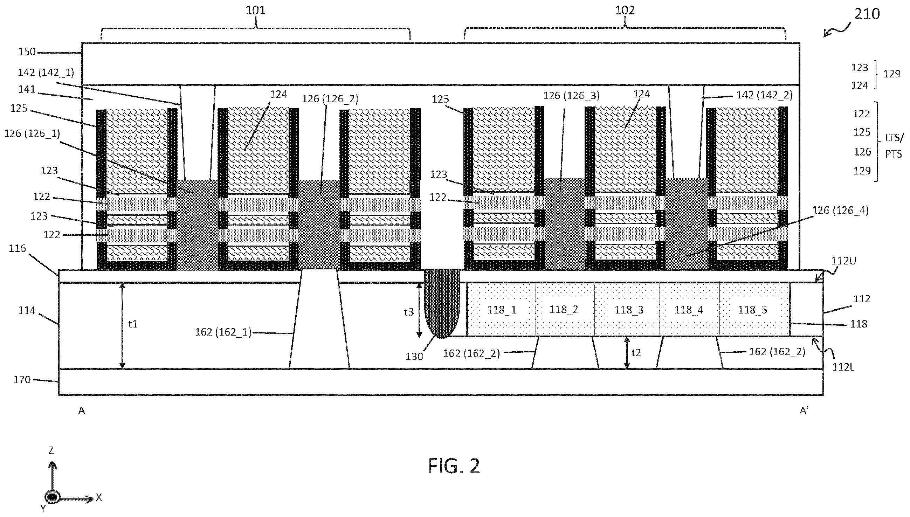

A dam 130 may be provided between the first device region 101 and the second device region 102. As illustrated in FIG. 1, the dam 130 may continuously extend between the first device region 101 and the second device region 102. However, the present disclosure is not limited thereto, and in some embodiments, the dam 130 may be discontinuously formed between first device region 101 and the second device region 102. For example, the dam 130 may only be formed in areas between backside contacts 162 (see FIG. 2) that are electrically connected to the first and second device regions 101 and 102. In FIG. 1, some elements (e.g., a second interlayer 141 and a back-end-of-line (BEOL) structure 150 on the dam 130 (see FIG. 2)) are not illustrated for convenience of illustration.

FIG. 2 is a cross-sectional view of an integrated circuit device 210 taken along the line A-A' in FIG. 1 according to some embodiments. Referring to FIG. 2, the integrated circuit device 210 may include a backside power distribution network structure (BSPDNS) 170 and a backside insulating layer 114. The BSPDNS 170 may include backside insulating layer(s) and a conductive element (e.g., a conductive wire or a conductive via plug) provided in the backside insulating layer(s). The first and second device regions 101 and 102 may be on the BSPDNS 170. The integrated circuit device 210 may include a substrate 112 that has an upper surface 112U and a lower surface 112L. The substrate 112 may be in the second device region 102. In some embodiments, the upper surface 112U of the substrate 112 may extend in a first direction X (also referred to as a first horizontal direction) and a second direction Y (also referred to as a second horizontal direction). The upper surface 112U of the substrate 112 may be parallel to the lower surface 112L of the substrate 112. Accordingly, the first direction X and the second direction Y may be parallel to the upper surface 112U and the lower surface 112L of the substrate 112. In some embodiments, the first direction X may be perpendicular to the second direction Y. The first direction X and the second direction Y may be parallel to an upper surface of the BSPDNS 170. Electric circuits may be provided on the upper surface 112U (also referred to as a first surface) of the substrate 112.

The substrate 112 may include semiconductor material(s), for example, Si, Ge, SiGe, GaP, GaAs, SiC, SiGeC and/or InP or may include insulating material(s), for example, silicon oxide, silicon oxynitride, silicon nitride, silicon carbonitride and/or a low-k material. In some embodiments, the substrate 112 may be a bulk substrate (e.g., a bulk silicon substrate) or a semiconductor on insulator (SOI) substrate. For example, the substrate 112 may be a silicon wafer or may be a single insulating layer. A thickness of the substrate 112 in a third direction Z (also referred to as a vertical direction) may be in a range of 50 nm to 100 nm. In some embodiments, the third direction Z may be perpendicular to the first direction X. In some embodiments, the third direction Z may be perpendicular to the upper surface 112U and/or the lower surface 112L of the substrate 112. For example, the low-k material may include fluorine-doped silicon oxide, organosilicate glass, carbon-doped oxide, porous silicon dioxide, porous organosilicate glass, spin-on organic polymeric dielectrics and/or spin-on silicon based polymeric dielectric.

The integrated circuit device 210 may further include a first interlayer 116 that may be provided on the upper surface 112U of the substrate 112. In some embodiments, the first interlayer 116 may extend on the substrate 112 in the first and second device regions 101 and 102 and may contact the upper surface 112U of the substrate 112. For example, the first interlayer 116 may include insulating material(s) (e.g., silicon oxide, silicon oxynitride, silicon nitride, silicon carbonitride and/or a low-k material).

The first device region 101 may include a logic transistor structure LTS. In some embodiments, the logic transistor structure LTS may be included in, for example, a Central Processing Unit (CPU), a Graphics Processing Unit (GPU), and/or a general logic circuit. The logic transistor structure LTS may include a gate structure 129 and a channel region 122 that comprises a portion provided in the gate structure 129. The channel region 122 may extend through the gate structure 129 in the first direction X. The logic transistor structure LTS may also include a pair of source/drain regions 126 (e.g., a first source/drain region 126_1 and a second source/drain region 126_2) that are on opposing side surfaces of the gate structure 129, respectively. The channel region 122 may include opposing side surfaces that are spaced apart from each other in the first direction X and respectively contact the pair of source/drain regions 126. The logic transistor structure LTS may include multiple channel regions 122 stacked in the third direction Z. In some embodiments, the logic transistor structure LTS may include two channel regions 122 stacked in the third direction Z as illustrated in FIG. 2. However, the present disclosure is not limited thereto, and the logic transistor structure LTS may include a single channel region 122 or may include more than two channel regions 122 stacked in the third direction Z.

The channel region 122 may include semiconductor material(s) (e.g., Si, Ge, SiGe, GaP, GaAs, SiC, SiGeC and/or InP). In some embodiments, the channel region 122 may be a nanosheet that may have a thickness in a range of from 1 nanometers (nm) to 100 nm in the third direction Z or may be a nanowire that may have a circular cross-section with a diameter in a range of from 1 nm to 100 nm.

The source/drain regions 126 may include a semiconductor layer (e.g., a silicon layer and/or a silicon germanium layer) and may additionally include dopants in the semiconductor layer. In some embodiments, the source/drain regions 126 may include a metallic layer that includes, for example, tungsten (W), aluminum (Al), copper (Cu), molybdenum (Mo), cobalt (Co) and/or ruthenium (Ru).

The logic transistor structure LTS may include multiple gate structures 129 (e.g., three gate structures in FIG. 2) that extend (e.g., extend longitudinally) in the second direction Y and are spaced apart from each other in the first direction X, as illustrated in FIG. 2. Each of the gate structures 129 may include a gate electrode 124 and a gate insulator 123 that separates the gate electrode 124 from the channel region 122. The gate insulator 123 may include a silicon oxide layer and/or a high-k material layer. The high-k material layer may include, for example, Al₂O₃, HfO₂, ZrO₂, HfZrO₄, TiOz, Sc₂O₃ Y₂O₃, La₂O₃, Lu₂O₃, Nb₂O₅ and/or Ta₂O₅. The gate electrode 124 may include a metallic layer that includes, for example W, Al, Cu, Mo, Co and/or Ru and may additionally include work function layer(s) (e.g., a TiN layer, a TaN layer, a TiAl layer, a TiC layer, a TiAlC layer, a TiAlN layer and/or a WN layer). The work function layer(s) may be provided between the metallic layer and the gate insulator 123. In some embodiments, the work function layer(s) may separate the metallic layer from the gate insulator 123.

The logic transistor structure LTS may include an insulating spacer 125 (also referred to as a gate spacer or an inner gate spacer) between the gate structure 129 and the source/drain regions 126 to separate the gate structure 129 from the source/drain regions 126. The insulating spacer 125 may include, for example, silicon oxide, silicon oxynitride, silicon nitride, silicon carbonitride, silicon boron nitride and/or a low-k material. The channel region 122 may extend through the insulating spacer 125 to contact the source/drain regions 126 on opposing sides of the gate structure 129 in the first direction X.

The second device region 102 may include a passive transistor structure PTS. In some embodiments, the passive transistor structure PTS may include the channel regions 122, the insulating spacer 125, the source/drain regions 126 (e.g., third and fourth source/drain regions 126_3 and 126_4), and the gate structure 129 having substantially the same structure as those included in the logic transistor structure LTS. For ease of description, repeated description of these elements will be omitted.

In some embodiments, the gate structure 129 included in the passive transistor structure PTS may be a dummy gate structure. For example, the gate structure 129 included in the passive transistor structure PTS may be a gate structure that does not function as a transistor or function electrically (e.g., non-active gate structures) and may be formed to replicate a physical structure of the gate structure 129 included in the logic transistor structure LTS. In other words, the passive transistor structure PTS may be a dummy structure which does not function as a transistor or function electrically and may be formed to replicate a physical structure of the logic transistor structure LTS. In some embodiments, the passive transistor structure PTS may not include the gate structure 129 and may instead include one or more sacrificial layers (not illustrated). The sacrificial layers may include material(s) different from the channel regions 122. For example, the sacrificial layers may include semiconductor material(s) (e.g., silicon germanium).

The second device region 102 may include the substrate 112. The substrate 112 may include a semiconductor layer 118 in the second device region 102. In other words, the second device region 102 may include the semiconductor layer 118. The semiconductor layer 118 may be in the backside insulating layer 114. The semiconductor layer 118 may include semiconductor material(s), for example, Si, Ge, SiGe, GaP, GaAs, SiC, SiGeC and/or InP. The semiconductor layer 118 may additionally include dopants. In other words, the semiconductor layer 118 may be a region including impurities. For example, the semiconductor layer 118 may include one or more regions that are doped with p-type impurities and/or n-type impurities. For example, the semiconductor layer may have first, second, third, fourth and fifth regions 118_1, 118_2, 118_3, 118_4, and 118_5.

The first, second, third, fourth and fifth regions 118_1, 118_2, 118_3, 118_4, and 118_5 may each include semiconductor material(s) (e.g., Si, Ge, SiGe, GaP, GaAs, SiC, SiGeC and/or InP) and may each additionally be doped with p-type impurities and/or n-type impurities. The first, second, third, fourth and fifth regions 118_1, 118_2, 118_3, 118_4, and 118_5 may have the same doping concentrations or different doping concentrations. The first, second, third, fourth and fifth regions 118_1, 118_2, 118_3, 118_4, and 118_5 are exemplary, and the semiconductor layer 118 may have any number of doped region(s) having varying doping types and/or doping concentrations to achieve a desired functionality for one or more passive elements (e.g., one or more of a resistor, a capacitor, an inductor, a transformer, a diode, and/or the like) included in the second device region 102. As an example, a diode may be formed in the semiconductor layer 118 as a P-N junction between a p-doped region and an n-doped region of the semiconductor layer 118, and a resistor may be formed in the semiconductor layer 118 as an n-doped or p-doped region. However, the present disclosure is not limited thereto, and various passive elements having the same or different configurations can be formed in the semiconductor layer 118.

In some embodiments, the semiconductor layer 118 may be formed by ion implantation. N-type or p-type impurities may be implanted in the semiconductor layer 118 by ionizing the desired ion species and accelerating the ions at a predetermined kinetic energy as an ion beam towards the surface of the semiconductor layer 118 in an ion implantation target chamber. Based on the predetermined kinetic energy, the desired ion species may penetrate into the semiconductor layer 118 to a certain depth. However, the present disclosure is not limited thereto, and in some embodiments, one or more regions of the semiconductor layer 118 may be epitaxially grown from the substrate 112. The n-type impurities may include, for example, nitrogen, phosphorus, or the like. The p-type impurities may include, for example, aluminum, boron, or the like.

A second interlayer 141 may be provided on the first interlayer 116. The logic transistor structure LTS and the passive transistor structure PTS may be provided in the second interlayer 141. Although FIG. 2 illustrates the second interlayer 141 as a single layer, in some embodiments, the second interlayer 141 may include multiple layers. The second interlayer 141 may include an insulating material(s) (e.g., silicon oxide, silicon oxynitride, silicon nitride, silicon carbonitride, silicon boron nitride and/or a low-k material).

Source/drain contacts 142 may extend in the second interlayer 141 on the source/drain regions 126 (e.g., the first source/drain region 126_1 and/or the fourth source/drain region 126_4). For example, a first source/drain contact 142_1 may be provided on the first source/drain region 126_1, and a second source/drain contact 142_2 may be provided on the fourth source/drain region 126_4. The first source/drain contact 142_1 may contact an upper surface of the first source/drain region 126_1 and may be electrically connected to the first source/drain region 126_1. The second source/drain contact 142_2 may contact an upper surface of the fourth source/drain region 126_4 and may be electrically connected to the fourth source/drain region 126_4. The source/drain contacts 142 may electrically connect the first source/drain region 126_1 and/or the fourth source/drain region 126_4 to a conductive element (e.g., a conductive wire or a conductive via plug) of a back-end-of-line (BEOL) structure 150 that is formed through the BEOL portion of device fabrication. As used herein, "a lower surface" refers to a surface facing the BSPDNS 170, and "an upper surface" refers to a surface opposite the lower surface. Further, as used herein, "a lower portion" refers to a portion that is closer than "an upper portion" to the BSPDNS 170 and thus is between the upper portion and the BSPDNS 170.

The BEOL structure 150 may include a BEOL insulating layer, conductive wires (e.g., metal wires) that are provided in the BEOL insulating layer and are stacked in the third direction Z, and conductive via plugs (e.g., metal via plugs), each of which may electrically connect two conductive wires that are spaced apart from each other in the third direction Z. The BEOL insulating layer may include, for example, silicon oxide, silicon oxynitride, silicon nitride, silicon carbonitride and/or a low-k material.

The integrated circuit device 210 may include the backside insulating layer 114 on the BSPDNS 170. The backside insulating layer 114 may include a first portion extending between the BSPDNS 170 and the first device region 101, and a second portion extending between the BSPDNS 170 and the second device region 102. The second portion of the backside insulating layer 114 may extend between the BSPDNS 170 and the semiconductor layer 118 of the second device region 102. The backside insulating layer 114 may extend between the dam 130 and the BSPDNS 170. The backside insulating layer 114 may be formed on the lower surface 112L (also referred to as a second surface) of the substrate 112. A thickness t1 of the backside insulating layer 114 in the third direction Z between the BSPDNS 170 and the first device region 101 (i.e., a thickness t1 of the first portion of the backside insulating layer 114) may be greater than a thickness t2 of the backside insulating layer 114 in the third direction Z between the BSPDNS 170 and the second device region 102 (i.e., a thickness t2 of the second portion of the backside insulating layer 114). By having the thickness t1 greater than the thickness t2, a step difference between the first device region 101 and the second device region 102 resulting from the semiconductor layer 118 and the substrate 112 may be alleviated. The backside insulating layer 114 may include, for example, silicon oxide, silicon oxynitride, silicon nitride, silicon carbonitride and/or a low-k material.

The integrated circuit device 210 may include the dam 130 separating a portion of the backside insulating layer 114 between the BSPDNS 170 and the first device region 101 (i.e., the first portion of the backside insulating layer 114) from the semiconductor layer 118 of the second device region 102. The dam 130 may extend into the first interlayer 116 and the backside insulating layer 114. A portion of the dam 130 that extends in the backside insulating layer 114 may have a thickness t3 in the third direction Z. The thickness t3 of the portion of the dam 130 may be less than the thickness t1 of the first portion of the backside insulating layer 114. The thickness t3 of the portion of the dam 130 may be greater than or equal to a thickness of the semiconductor layer 118 in the third direction Z. A lower surface of the dam 130 may be coplanar with or lower than a lower surface of the semiconductor layer 118. In other words, a distance between an upper surface of the BSPDNS 170 and the lower surface of the semiconductor layer 118 may be greater than or equal to a distance between the upper surface of the BSPDNS 170 and the lower surface of the dam 130. The dam 130 may be between a portion of the backside insulating layer 114 between the BSPDNS 170 and the first device region 101 (i.e., the first portion of the backside insulating layer 114) and the semiconductor layer 118 in the first direction X and/or the second direction Y. That is, the dam 130 may be between the first portion of the backside insulating layer 114 and the semiconductor layer 118 in the first direction X and/or the second direction Y.

The dam 130 may be self-aligned with respect to a pair of gate structures 129 respectively included in the first device region 101 and the second device region 102. The pair of gate structures 129 respectively included in the first device region 101 and the second device region 102 may be adjacent to each other without any intervening gate structure and/or any source/drain region therebetween. For example, the dam 130 may be spaced apart equally in the first direction X from the pair of gate structures 129 respectively included in the first device region 101 and the second device region 102. In other words, the dam 130 may be spaced apart equally in the first direction X from the first device region 101 and the second device region 102.

In some embodiments, side surfaces of the dam 130 may be spaced apart from the insulating spacer 125 in the first direction X. A portion of the side surfaces of the dam 130 in the first interlayer 116 may have an inclination angle of about 90 degrees with respect to an upper surface of the first interlayer 116. However, the present disclosure is not limited thereto, and in some embodiments, the portion of the side surfaces of the dam 130 in the first interlayer 116 may have an inclination angle of less than or greater than about 90 degrees with respect to the upper surface of the first interlayer 116. The dam 130 may extend between the backside insulating layer 114 and a side surface of the semiconductor layer 118. An upper surface of the dam 130 may be coplanar with an upper surface the first interlayer 116. The dam 130 may have a lower surface with a round profile. For example, the lower surface of the dam 130 may have a convex shape. The dam 130, however, is not limited to the shape illustrated in the drawings, and may be formed in various shapes depending on processes and materials. Although not illustrated in FIG. 2, a barrier layer or a silicide layer may be formed on and in contact with an upper surface of the dam 130. The barrier layer may include, for example, titanium, titanium nitride, tantalum, tantalum nitride, as well as other metal nitrides and/or intermetallics, including, for example cobalt, ruthenium, and/or the like.

The dam 130 may include a material different from that of the substrate 112. For example, the substrate 112 may include silicon (Si) and the dam 130 may include silicon germanium (SiGe). However, the present disclosure is not limited thereto, and the substrate 112 and the dam 130 may include other materials which are different from each other. In some embodiments, when the dam 130 includes silicon germanium, a concentration of germanium in the dam 130 may be between 35 to 65 at%. For example, the concentration of germanium in the dam 130 may be about 50 at%. In some embodiments, a thickness of the dam 130 may be between 55 to 85 nanometers (nm). For example, a thickness of the dam 130 may be about 70 nm. However, the present disclosure is not limited thereto, and the dam 130 may have other thicknesses so long as a lower surface of the dam 130 is coplanar with or lower than a lower surface of the semiconductor layer 118.

The integrated circuit device 210 may further include backside contacts 162 and the BSPDNS 170. The backside contacts 162 may extend in the backside insulating layer 114. A first backside contact 162_1 may include an upper portion in the first interlayer 116 and a lower portion in the backside insulating layer 114. In some embodiments, the first backside contact 162_1 may extend in the first interlayer 116 and the backside insulating layer 114 in the third direction Z, and the first backside contact 162_1 (e.g., an upper surface of the first backside contact 162_1) may contact the second source/drain region 126_2 (e.g., a lower surface of the second source/drain region 126_2), as illustrated in FIG. 2. The upper surface of the first backside contact 162_1 may be coplanar with an upper surface of the dam 130. The upper surface of the first backside contact 162_1 may be free of the first interlayer 116 thereon, and the first backside contact 162_1 may be electrically connected to the second source/drain region 126_2.

Second backside contacts 162_2 may extend in the backside insulating layer 114 in the third direction Z. The second backside contacts 162_2 (e.g., upper surfaces of the second backside contacts 162_2) may contact the semiconductor layer 118 (e.g., a lower surface of the semiconductor layer 118), as illustrated in FIG. 2. The upper surfaces of the second backside contacts 162_2 may be free of the backside insulating layer 114 thereon, and the second backside contacts 162_2 may be electrically connected to one or more regions (e.g., the second and fourth regions 118_2 and 118_4) of the semiconductor layer 118. Although FIG. 2 illustrates that two second backside contacts 162_2 are included in the integrated circuit device 210, the present disclosure is not limited thereto, and the integrated circuit device 210 may include any number (e.g., one or more) of the second backside contacts 162_2 to achieve a desired functionality for one or more passive devices included in the second device region 102. In addition, although FIG. 2 illustrates that the second backside contacts 162_2 are electrically connected to the second and fourth regions 118_2 and 118_4 of the semiconductor layer 118, the present disclosure is not limited thereto, and the second backside contact(s) 162_2 may be electrically connected in various arrangements to the semiconductor layer 118 to achieve a desired functionality for one or more passive devices included in the second device region 102. By forming the second backside contacts 162_2 in the backside insulating layer 114 instead of the second interlayer 141, a height (e.g., thickness) of the second backside contacts 162_2 in the third direction Z may be reduced, thereby reducing a resistance of the integrated circuit device 210.

Lower surfaces of the backside contacts 162 (e.g., lower surfaces of the first and second backside contacts 162_1 and 162_2) may be coplanar with one another. Lower surfaces of the backside contacts 162 may be in contact with the BSPDNS 170. A height (e.g., thickness) in the third direction Z of the first backside contact 162_1 may be greater than a height (e.g., thickness) in the third direction Z of the second backside contacts 162_2. In some embodiments, a width of the backside contacts 162 in the first direction X may decrease with increasing distance from the BSPDNS 170 in the third direction Z, as illustrated in FIG. 2. In some embodiments, a width of the backside contacts 162 in the second direction Y may also decrease with increasing distance from the B SPDNS 170 in the third direction Z. However, the present disclosure is not limited thereto, and in some embodiments, a width of the backside contacts 162 in the first direction X and/or the second direction Y may increase with increasing distance from the BSPDNS 170 in the third direction Z. Although not illustrated in FIG. 2, a barrier layer or a silicide layer may be formed on and in contact with respective upper surfaces of the backside contacts 162. The barrier layer may include, for example, titanium, titanium nitride, tantalum, tantalum nitride, as well as other metal nitrides and/or intermetallics, including, for example cobalt, ruthenium, and/or the like.

The first backside contact 162_1 may be electrically connected to the B SPDNS 170 and the second source/drain region 126_2. The first backside contact 162_1 may electrically connect the second source/drain region 126_2 to a conductive element (e.g., a conductive wire or a conductive via plug) of the BSPDNS 170. The BSPDNS 170 may include, for example, a power rail and a backside insulator in which the power rail is provided. The power rail may be electrically connected to a power source with a predetermined voltage (e.g., a drain voltage or a source voltage), and thus the second source/drain region 126_2 may be electrically connected to the power source through the first backside contact 162_1 and the power rail. In some embodiments, the first backside contact 162_1 may contact both the second source/drain region 126_2 and the power rail. The backside insulator in the BSPDNS 170 may be a single layer or may include multiple layers stacked on a lower surface of the backside insulating layer 114. The BSPDNS 170 may be separated from the substrate 112, the semiconductor layer 118, and the dam 130 by the backside insulating layer 114.

The second backside contacts 162_2 may be electrically connected to the BSPDNS 170 and the semiconductor layer 118. The second backside contacts 162_2 may electrically connect one or more of the first, second, third, fourth, and fifth regions 118_1, 118_2, 118_3, 118_4, and 118_5 of the semiconductor layer 118 to a conductive element (e.g., a conductive wire or a conductive via plug) of the BSPDNS 170. The one or more of the first, second, third, fourth, and fifth regions 118_1, 118_2, 118_3, 118_4, and 118_5 of the semiconductor layer 118 may be electrically connected to a power source through the second backside contacts 162_2 and the power rail. Each of the backside contacts 162 and the power rail may include, for example, metal element(s) (e.g., W, Al, Cu, Mo and/or Ru), and the backside insulator of the BSPDNS 170 may include, for example, silicon oxide, silicon oxynitride, silicon nitride, silicon carbonitride and/or a low-k material.

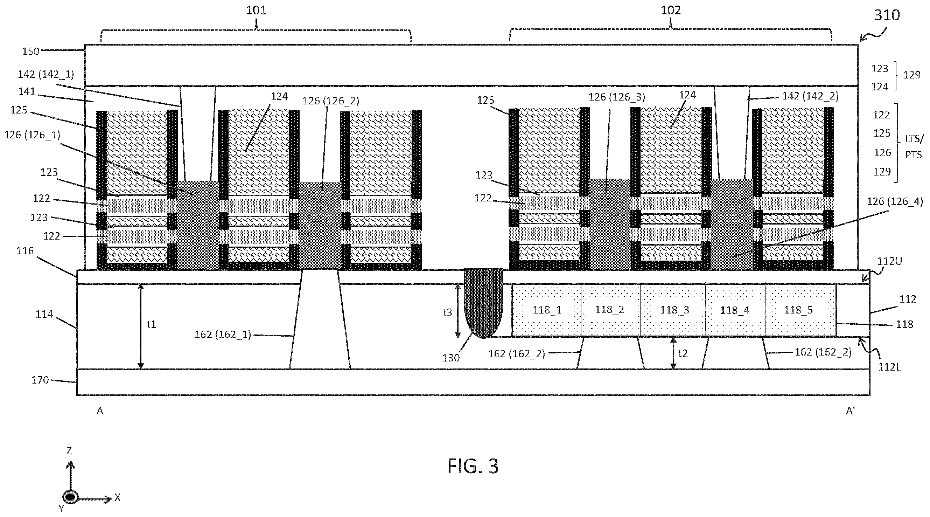

FIG. 3 is a cross-sectional view of an integrated circuit device 310 taken along the line A-A' in FIG. 1 according to some embodiments. Referring to FIG. 3, the integrated circuit device 310 may be substantially the same as the integrated circuit device 210 described with reference to FIG. 2, and thus repeated description of like elements will be omitted. Unlike the integrated circuit device 210 illustrated in FIG. 2, the integrated circuit device 310 may have a dam 130 that is not self-aligned with respect to a pair of gate structures 129 respectively included in the first device region 101 and the second device region 102. The pair of gate structures 129 respectively included in the first device region 101 and the second device region 102 may be adjacent to each other. For example, the integrated circuit device 310 may have the dam 130 spaced farther apart in the first direction X from an insulating spacer 125 included in the logic transistor structure LTS and/or an insulating spacer 125 included in the passive transistor structure PTS than the dam 130 of the integrated circuit device 210 illustrated in FIG. 2.

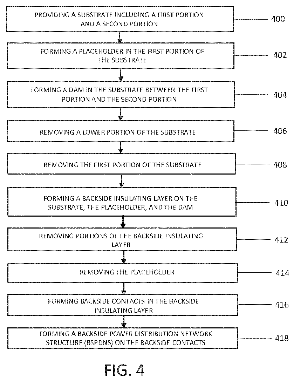

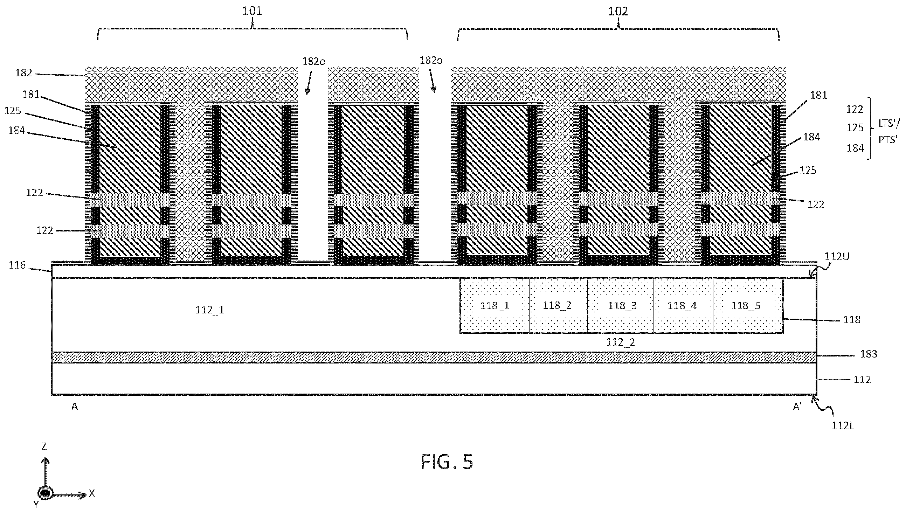

FIG. 4 is a flow chart of a method of forming the integrated circuit device 210 of FIG. 2 according to some embodiments, and FIGS. 5 through 12 are cross-sectional views illustrating those method according to some embodiments.

Referring to FIGS. 4 and 5, the method may include providing a substrate 112 including a first portion 112_1 and a second portion 112_2 (BLOCK 400). The first portion 112_1 of the substrate 112 may be in a first device region 101, and the second portion 112_2 of the substrate 112 may be in a second device region 102. The substrate 112 may have an upper surface 112U and a lower surface 112L. Electric circuits may be provided on the upper surface 112U (also referred to as a first surface) of the substrate 112.

The substrate 112 may include semiconductor material(s), for example, Si, Ge, SiGe, GaP, GaAs, SiC, SiGeC and/or InP or may include insulating material(s), for example, silicon oxide, silicon oxynitride, silicon nitride, silicon carbonitride and/or a low-k material. In some embodiments, the substrate 112 may be a bulk substrate (e.g., a bulk silicon substrate) or a semiconductor on insulator (SOI) substrate. For example, the substrate 112 may be a silicon wafer or may be a single insulating layer. A thickness of the substrate 112 in a third direction Z (also referred to as a vertical direction) may be in a range of 50 nm to 100 nm. For example, the low-k material may include fluorine-doped silicon oxide, organosilicate glass, carbon-doped oxide, porous silicon dioxide, porous organosilicate glass, spin-on organic polymeric dielectrics and/or spin-on silicon based polymeric dielectric.

The substrate 112 may include the semiconductor layer 118 including the first, second, third, fourth, and fifth regions 118_1, 118_2, 118_3, 118_4, and 118_5 described with reference to FIG. 2. The semiconductor layer 118 may be formed in the second portion 112_2 of the substrate 112. As described earlier with reference to FIG. 2, in some embodiments, the semiconductor layer 118 may be formed by ion implantation. N-type or p-type impurities may be implanted in the semiconductor layer 118 by ionizing the desired ion species and accelerating the ions at a predetermined kinetic energy as an ion beam towards the surface of the semiconductor layer 118 in an ion implantation target chamber. Based on the predetermined kinetic energy, the desired ion species may penetrate into the semiconductor layer 118 to a certain depth. However, the present disclosure is not limited thereto, and in some embodiments, one or more regions of the semiconductor layer 118 may be epitaxially grown from the substrate 112 by an epitaxial growth process. The n-type impurities may include, for example, nitrogen, phosphorus, or the like. The p-type impurities may include, for example, aluminum, boron, or the like.

The first interlayer 116 described with reference to FIG. 2 may be provided on the upper surface 112U of the substrate 112. The first interlayer 116 may include, for example, silicon oxide, silicon oxynitride, silicon nitride, silicon carbonitride and/or a low-k material.

A preliminary logic transistor structure LTS' and a preliminary passive transistor structure PTS' may be provided on the first interlayer 116. Each of the preliminary logic transistor structure LTS' and the preliminary passive transistor structure PTS' may include the channel regions 122 and the insulating spacer 125 described with reference to FIG. 2. Each of the preliminary logic transistor structure LTS' and the preliminary passive transistor structure PTS' may further include sacrificial layers 184. The sacrificial layers 184 may be alternately stacked with the channel regions 122 in the third direction Z. The sacrificial layers 184 may include material(s) different from the channel regions 122 such that the sacrificial layers 184 can be selectively removed from the preliminary logic transistor structure LTS' and the preliminary passive transistor structure PTS' to form gate structures (e.g., the gate structures 129 of FIG. 2). For example, the sacrificial layers 184 may include semiconductor material(s) (e.g., silicon germanium).

A gate liner 181 may be formed on side surfaces and upper surfaces of the preliminary logic transistor structure LTS' and the preliminary passive transistor structure PTS'. The gate liner 181 may include, for example, a layer including nitrogen (e.g., SiN, SiON, SiBCN, SiOCN, SiBN and/or SiCN) and may have a thickness, for example, in a range of from 1 nm to 5 nm (e.g., about 1 nm or 2 nm).

A first mask layer 182 may be provided on the preliminary logic transistor structure LTS' and the preliminary passive transistor structure PTS'. The first mask layer 182 may include first mask openings 182o. One of the first mask openings 182o may be provided on a space between the preliminary logic transistor structure LTS' and the preliminary passive transistor structure PTS' (e.g., between the first device region 101 and the second device region 102). The other one of the first mask openings 182o may be provided on the preliminary logic transistor structure LTS' on a space where a source/drain region is to be formed (e.g., the second source/drain region 126_2 of FIG. 2). The first mask layer 182 may include an organic material (e.g., a photoresist) and/or an inorganic material (e.g., silicon oxynitride and/or a spin-on-glass material).

An etch stop layer 183 may be formed in the substrate 112. The etch stop layer 183 may be formed between a lower portion and an upper portion of the substrate 112. The etch stop layer 183 may include a material having an etch selectivity with respect to the substrate 112. The etch stop layer 183 may include, for example, SiN, SiBCN, SiOCN, SiBN, SiCN, SiO and/or SiON.

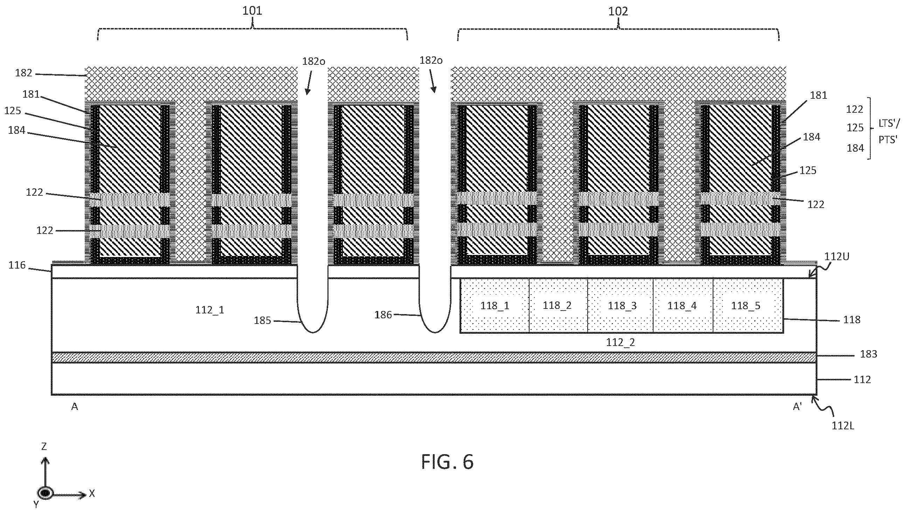

Referring to FIG. 6, the first mask layer 182 may be used as an etch mask. A first recess 185 and a second recess 186 may be formed in the first interlayer 116 and the substrate 112 respectively below the first mask openings 182o. For example, the first recess 185 and the second recess 186 may be formed by performing an etch process (e.g., a dry etch process and/or a wet etch process) in the first mask openings 182o on an upper surface of the first interlayer 116 and an upper surface of the substrate 112 to remove portions thereof. The first recess 185 and the second recess 186 may be formed in a self-aligned manner. For example, the first recess 185 and the second recess 186 may be self-aligned using side surfaces of the gate liner 181 during the etch process. Side surfaces of the first recess 185 may be coplanar with side surfaces of the gate liner 181 thereon. Similarly, side surfaces of the second recess 186 may be coplanar with side surfaces of the gate liner 181 thereon.

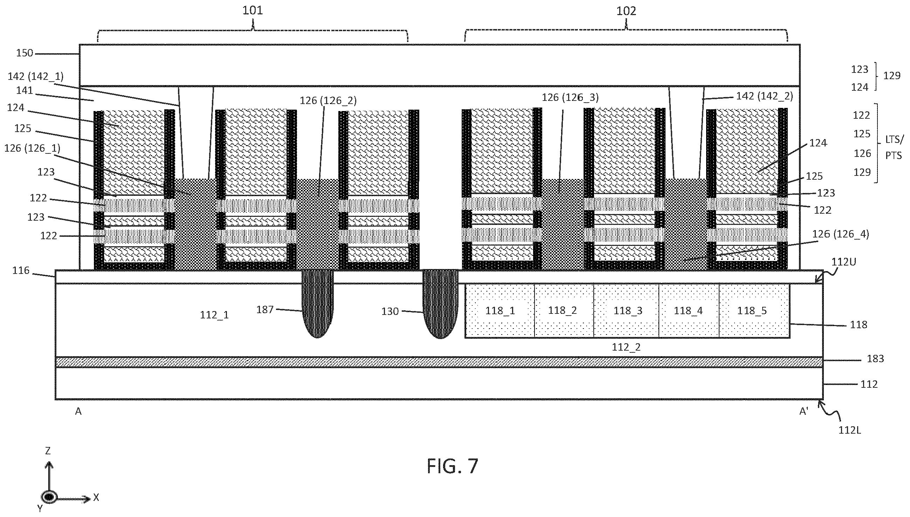

Referring to FIGS. 4 and 7, the first mask layer 182 and the gate liner 181 may be removed. A placeholder 187 may be formed in the first portion 112_1 of the substrate 112 (BLOCK 402). A dam 130 may be formed in the substrate 112 between the first portion 112_1 of the substrate 112 and the second portion 112_2 of the substrate 112 (BLOCK 404). The placeholder 187 may be formed in the first recess 185 of FIG. 6, and the dam 130 may be formed in the second recess 186 of FIG. 6. For example, the placeholder 187 and the dam 130 may be formed by performing an epitaxial growth process using the substrate 112. Specifically, the placeholder 187 and the dam 130 may be grown from the substrate 112 through an epitaxial growth process. The placeholder 187 and the dam 130 may include a material different from that of the substrate 112. For example, the substrate 112 may include silicon (Si), and both of the placeholder 187 and the dam 130 may include silicon germanium (SiGe). However, the present disclosure is not limited thereto, and the substrate 112, the placeholder 187, and the dam 130 may include other materials. In some embodiments, when the placeholder 187 and the dam 130 include silicon germanium, a concentration of germanium in the placeholder 187 and the dam 130 may be between 35 to 65 at%. For example, the concentration of germanium in the placeholder 187 and the dam 130 may be about 50 at%. When the sacrificial layers 184 of FIGS. 5 and 6 include silicon germanium and the placeholder 187 and the dam 130 include silicon germanium, a concentration of germanium in the placeholder 187 and the dam 130 may be different from that of the sacrificial layers 184.

The placeholder 187 and the dam 130 may be formed by the same fabrication process, at approximately (but not necessarily exactly) the same time, or may be formed by different fabrication processes. In some embodiments, a width of the dam 130 in the first direction X and/or the second direction Y may be greater than a width of the placeholder 187 in the first direction X and/or the second direction Y. An upper surface of the placeholder 187 may be coplanar with an upper surface of the dam 130. Lower surfaces of the placeholder 187 and the dam 130 may be spaced apart from the etch stop layer 183 with a portion of the substrate 112 therebetween.

The source/drain regions 126 (e.g., the first, second, third, and fourth source/drain regions 126_1, 126_2, 126_3, and 126_4) described with reference to FIG. 2 may be formed by performing an epitaxial growth process using the channel regions 122 as a seed layer. Specifically, the source/drain regions 126 may be grown from opposing side surfaces of the channel regions 122 through an epitaxial growth process. Although not shown in FIG. 7, a source/drain region (also referred to as a dummy source/drain region) may be grown on the dam 130 between the logic transistor structure LTS and the passive transistor structure PTS, and then the dummy source/drain region may be removed through subsequent process(es). In some embodiments, a dummy source/drain region may not be grown on the dam 130 using a selective growth process. For example, an inhibition layer inhibiting an epitaxial growth may be formed on the dam 130 and/or channel regions 122 adjacent to the dam 130 such that a dummy source/drain region may not be formed on the dam 130, as illustrated in FIG. 7.

After forming the source/drain regions 126, the sacrificial layers 184 of FIGS. 5 and 6 may be removed and replaced with the gate insulators 123 and the gate electrodes 124 described with reference to FIG. 2 to form gate structures 129 in the logic transistor structure LTS and the passive transistor structure PTS. In some embodiments, although not shown in FIG. 7, the sacrificial layers 184 included in the preliminary passive transistor structure PTS' may not be removed and replaced with the gate insulators 123 and the gate electrodes 124. That is, in some embodiments, the passive transistor structure PTS may include the sacrificial layers 184 and may not include the gate insulators 123 and the gate electrodes 124. The passive transistor structure PTS may be a dummy structure which does not function as a transistor or function electrically and may be formed to replicate a physical structure of the logic transistor structure LTS for easy and accuracy of processes (e.g., a lithography process and/or an etch process). In some embodiments, the passive transistor structures PTS may be removed by subsequent process(es).

In addition, the second interlayer 141, the source/drain contacts 142 (e.g., the first and second source/drain contacts 142_1 and 142_2), and the BEOL structure 150 described with reference to FIG. 2 may also be formed.

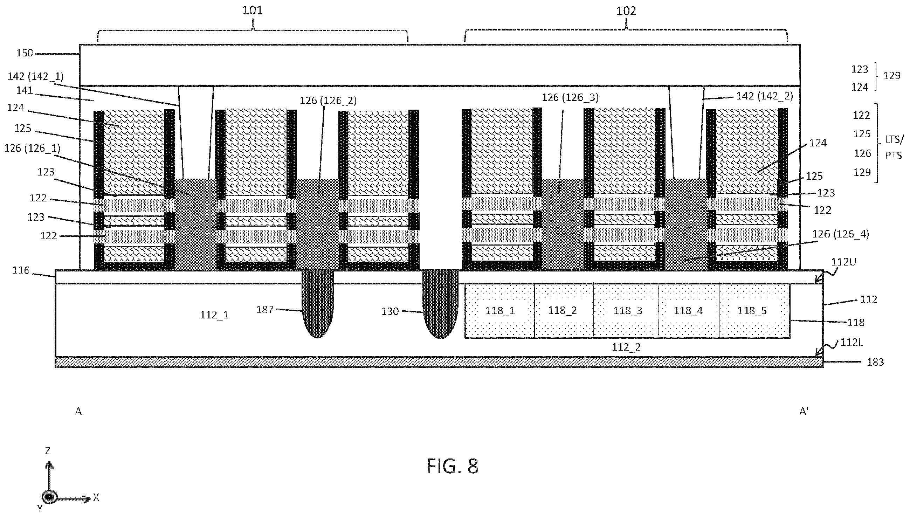

Referring to FIGS. 4 and 8, a lower portion of the substrate 112 may be removed (BLOCK 406). In some embodiments, the structure shown in FIG. 7 may be turned around (e.g., flipped), and a lower portion of the substrate 112 may be removed. For example, process(es) (e.g., a grinding process, a wet etching process, a dry etching process and/or a Chemical Mechanical Polishing (CMP) process) may be performed to remove the lower portion (e.g., backside) of the substrate 112 until reaching the etch stop layer 183.

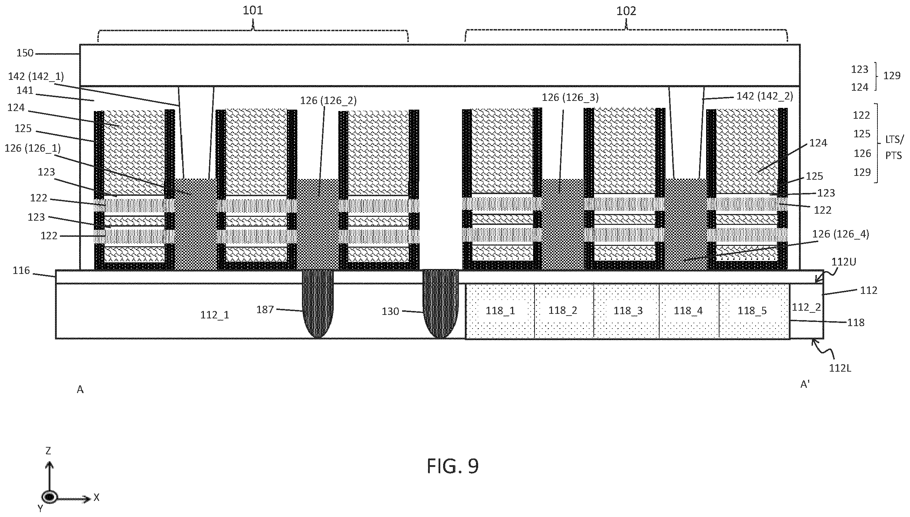

Referring to FIG. 9, the etch stop layer 183 may be removed. For example, process(es) (e.g., a grinding process, a wet etching process, a dry etching process and/or a Chemical Mechanical Polishing (CMP) process) may be performed to remove the etch stop layer 183 until reaching lower surfaces of the placeholder 187 and the dam 130. A remaining portion of the substrate 112 beneath the placeholder 187 and the dam 130 may also be removed.

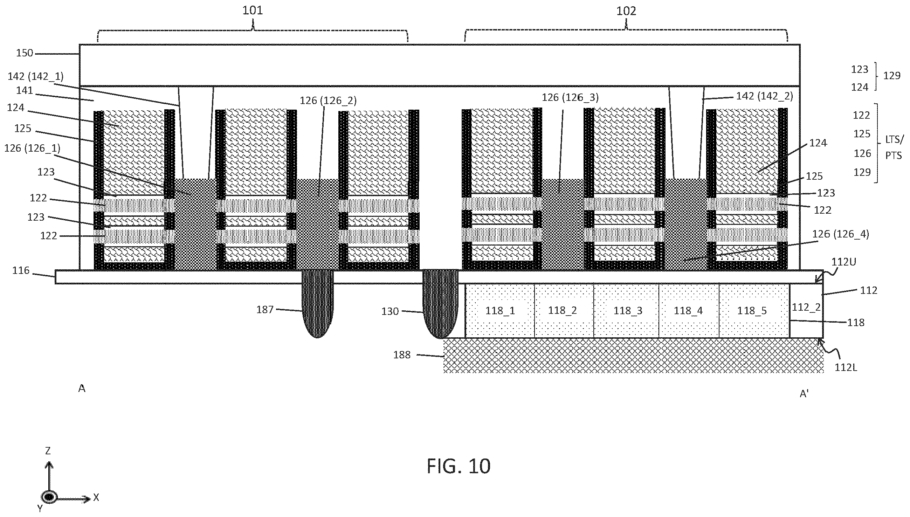

Referring to FIGS. 4 and 10, a second mask layer 188 may be provided on a lower surface of the second portion 112_2 of the substrate 112. The second mask layer 188 may be provided on a lower surface of the semiconductor layer 118. The second mask layer 188 may be used as an etch mask and may include an organic material (e.g., a photoresist) and/or an inorganic material (e.g., silicon oxynitride and/or a spin-on-glass material). The first portion 112_1 of the substrate 112 may then be removed (BLOCK 408). For example, process(es) (e.g., a grinding process, a wet etching process, a dry etching process and/or a Chemical Mechanical Polishing (CMP) process) may be performed to remove the first portion 112_1 of the substrate 112 until reaching the first interlayer 116. The placeholder 187 and the dam 130 may include a different material than the substrate 112 and may thus have etch selectivity with respect to the first portion 112_1 of the substrate 112.

The dam 130 may prevent or mitigate an etch material used in the process(es) to remove the first portion 112_1 of the substrate 112 from spreading to the second device region 102. For example, the dam 130 may prevent or mitigate the etch material from spreading to and damaging portions of the semiconductor layer 118 in the second device region 102, thereby protecting the semiconductor layer 118 from damage during removal of the first portion 112_1 of the substrate 112. The dam 130 may thus protect the second device region 102 during formation of a BSPDNS 170 to be described later (see FIG. 2) for the first and second device regions 101 and 102.

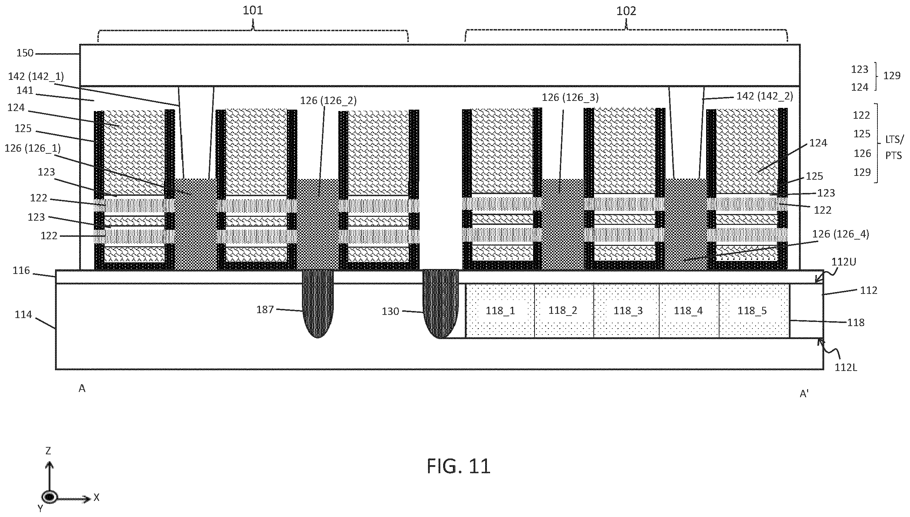

Referring to FIGS. 4 and 11, the second mask layer 188 may be removed. A backside insulating layer 114 may be formed on the substrate 112, the placeholder 187, and the dam 130 (BLOCK 410). For example, the backside insulating layer 114 may be formed on the lower surface 112L (also referred to as a second surface) of the substrate 112. The removal of the first portion 112_1 of the substrate 112 may result in a thickness difference (e.g., a step difference) between the first device region 101 and the second device region 102, which can cause problems with subsequent processes for forming a BSPDNS 170 to be described later (see FIG. 2) for the first and second device regions 101 and 102. The backside insulating layer 114 may alleviate the step difference between the first device region 101 and the second device region 102 caused by the removal of the first portion 112_1 of the substrate 112, thereby facilitating the formation of a BSPDNS 170 for the first and second device regions 101 and 102. The backside insulating layer 114 may include, for example, silicon oxide, silicon oxynitride, silicon nitride, silicon carbonitride and/or a low-k material. The semiconductor layer 118 may be in the backside insulating layer 114.

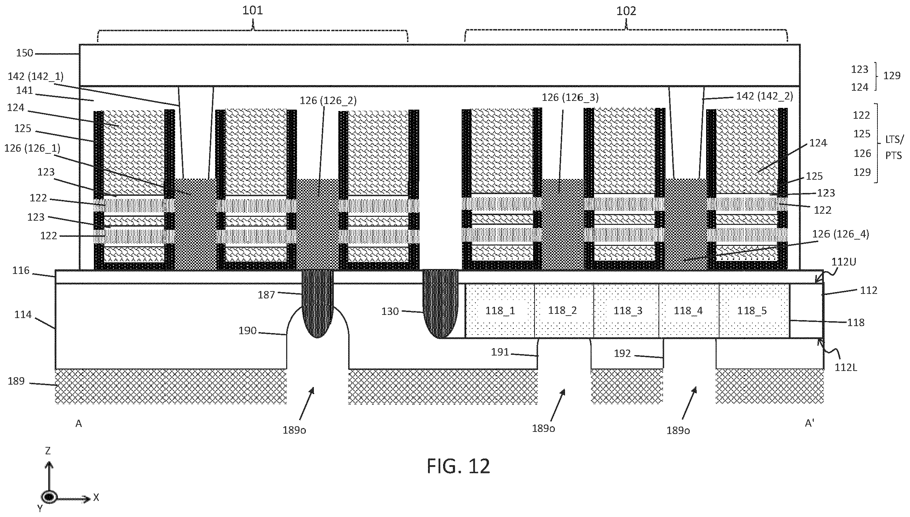

Referring to FIGS. 4 and 12, a third mask layer 189 may be formed on a lower surface of the backside insulating layer 114. The third mask layer 189 may include third mask openings 189o. One of the third mask openings 189o may be provided on a lower surface of the placeholder 187. The other ones of the third mask openings 189o may be provided on a lower surface of the semiconductor layer 118 (e.g., on lower surfaces of the second and fourth regions 118_2 and 118_4 of the semiconductor layer 118). The one of the third mask openings 189o may correspond to the first device region 101, and the other ones of the third mask openings 189o may correspond to the second device region 102. The third mask layer 189 may be used as an etch mask and may include an organic material (e.g., a photoresist) and/or an inorganic material (e.g., silicon oxynitride and/or a spin-on-glass material). Portions of the backside insulating layer 114 may then be removed (BLOCK 412). For example, a portion of the backside insulating layer 114 on a lower surface of the placeholder 187 may be removed, and portions of the backside insulating layer 114 on a lower surface of the semiconductor layer 118 (e.g., on a lower surface of the second and fourth regions 118_2 and 118_4 of the semiconductor layer 118) may be removed. A third recess 190, a fourth recess 191, and a fifth recess 192 may thus be formed in the backside insulating layer 114 respectively on the third mask openings 189o. For example, the third, fourth, and fifth recesses 190, 191, and 192 may be formed by performing an etch process (e.g., a dry etch process and/or a wet etch process) in the third mask openings 189o on the lower surface of the backside insulating layer 114 to remove portions thereof. The placeholder 187, the semiconductor layer 118, and the substrate 112 may include a different material than the backside insulating layer 114 and may thus have an etch selectivity with respect to the backside insulating layer 114. Accordingly, the backside insulating layer 114 may be selectively etched without etching the placeholder 187, the semiconductor layer 118, and the substrate 112.

Referring back to FIGS. 2 and 4, the placeholder 187 may be removed (BLOCK 414). For example, an etch process (e.g., a dry etch process and/or a wet etch process) may be performed to remove the placeholder 187 of FIG. 12. The removal of the placeholder 187 may create a space in the backside insulating layer 114 and the first interlayer 116 on the third recess 190 of FIG. 12. The backside contacts 162 may be formed in the backside insulating layer 114 (BLOCK 416).

In some embodiments, as illustrated in FIG. 2, the first backside contact 162_1 may be formed in the third recess 190 and the space created by the removal of the placeholder 187. The first backside contact 162_1 may extend in the third direction Z in the third recess 190 and may be formed in the space created by the removal of the placeholder 187 to contact a lower surface of the second source/drain region 126_2. The second backside contacts 162_2 may respectively be formed in the fourth and fifth recesses 191 and 192 of FIG. 12 to contact a lower surface of the semiconductor layer 118 (e.g., lower surfaces of the second and fourth regions 118_2 and 118_4 of the semiconductor layer 118). The first and second backside contacts 162_1 and 162_2 may be electrically connected to electric circuits on the upper surface 112U of the substrate 112. For example, the first backside contact 162_1 may be electrically connected to the second source/drain region 126_2, and the second backside contacts 162_2 may be electrically connected to the semiconductor layer 118 (e.g., the second and fourth regions 118_2 and 118_4 of the semiconductor layer 118). By forming the second backside contacts 162_2 in the backside insulating layer 114 instead of the second interlayer 141, a height (e.g., thickness) of the second backside contacts 162_2 in the third direction Z may be reduced, thereby reducing a resistance of the integrated circuit device 210.

Still referring to FIG. 2, the BSPDNS 170 may be formed on the backside contacts 162 (BLOCK 418). The B SPDNS 170 may contact lower surfaces of the backside contacts 162 and may be electrically connected to the backside contacts 162. The first backside contact 162_1 may be between the first device region 101 and the BSPDNS 170, and the second backside contacts 162_2 may be between the second device region 102 and the BSPDNS 170. The first backside contact 162_1 may be electrically connected to the first device region 101, and the second backside contacts 162_2 may be electrically connected to the second device region 102. The backside insulating layer 114 may extend between the dam 130 and the BSPDNS 170.

The first backside contact 162_1 may electrically connect the second source/drain region 126_2 to a conductive element (e.g., a conductive wire or a conductive via plug) of the BSPDNS 170. The BSPDNS 170 may include, for example, a power rail and a backside insulator in which the power rail is provided. The power rail may be electrically connected to a power source with a predetermined voltage (e.g., a drain voltage or a source voltage), and thus the second source/drain region 126_2 may be electrically connected to the power source through the first backside contact 162_1 and the power rail. In some embodiments, the first backside contact 162_1 may contact both the second source/drain region 126_2 and the power rail. The backside insulator in the BSPDNS 170 may be a single layer or may include multiple layers stacked on a lower surface of the backside insulating layer 114. The BSPDNS 170 may be separated from the substrate 112, the semiconductor layer 118, and the dam 130 by the backside insulating layer 114.

The second backside contacts 162_2 may be also electrically connected to the BSPDNS 170 and the semiconductor layer 118. The second backside contacts 162_2 may electrically connect one or more of the first, second, third, fourth, and fifth regions 118_1, 118_2, 118_3, 118_4, and 118_5 of the semiconductor layer 118 to a conductive element (e.g., a conductive wire or a conductive via plug) of the BSPDNS 170. The one or more of the first, second, third, fourth, and fifth regions 118_1, 118_2, 118_3, 118_4, and 118_5 of the semiconductor layer 118 may be electrically connected to a power source through the second backside contacts 162_2 and the power rail. Each of the backside contacts 162 and the power rail may include, for example, metal element(s) (e.g., W, Al, Cu, Mo and/or Ru), and the backside insulator of the BSPDNS 170 may include, for example, silicon oxide, silicon oxynitride, silicon nitride, silicon carbonitride and/or a low-k material.

It will be understood that the integrated circuit device 310 described with reference to FIG. 3 can be formed by methods similar to those described with reference to FIGS. 5 through 12 with appropriate modification thereto. For example, unlike the integrated circuit device 210, the integrated circuit device 310 may be formed by forming the second recess 186 described with reference to FIG. 6 in a manner that is not self-aligned. For example, the second recess 186 may not be self-aligned with side surfaces of the gate liner 181 during an etch process, and thus side surfaces of the second recess 186 may not be coplanar with side surfaces of the gate liner 181 thereon. The integrated circuit device 310 may thus have the dam 130 spaced farther apart in the first direction X from an insulating spacer 125 included in the logic transistor structure LTS and/or an insulating spacer 125 included in the passive transistor structure PTS than the dam 130 of the integrated circuit device 210.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing. Although an element is illustrated as a single layer in the drawings, that element may include multiple layers.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

The above-disclosed subject matter is to be considered illustrative, and not restrictive, and the appended claims are intended to cover all such modifications, enhancements, and other embodiments, which fall within the scope of the present invention. Thus, to the maximum extent allowed by law, the scope is to be determined by the broadest permissible interpretation of the following claims and their equivalents, and shall not be restricted or limited by the foregoing detailed description.

## Claims

1. An integrated circuit device comprising:
a backside power distribution network structure, BSPDNS;
a logic device region and a passive device region on the BSPDNS;
a backside insulating layer comprising a first portion extending between the BSPDNS and the logic device region and a second portion extending between the BSPDNS and the passive device region, the passive device region comprising a semiconductor layer that is in the backside insulating layer; and
a dam separating the first portion of the backside insulating layer from the semiconductor layer of the passive device region.

2. The integrated circuit device of Claim 1, further comprising a first backside contact in the backside insulating layer, wherein the first backside contact is electrically connected to a source/drain region of the logic device region.

3. The integrated circuit device of Claim 2, wherein an upper surface of the dam is coplanar with an upper surface of the first backside contact, and
wherein the dam is between the first portion of the backside insulating layer and the semiconductor layer in a direction parallel to an upper surface of the BSPDNS.

4. The integrated circuit device of Claim 2 or 3, further comprising a second backside contact in the backside insulating layer, wherein the semiconductor layer comprises a region including impurities, and
wherein the second backside contact is electrically connected to the region including the impurities.

5. The integrated circuit device of Claim 4, wherein a lower surface of the first backside contact is coplanar with a lower surface of the second backside contact.

6. The integrated circuit device of Claim 4 or 5, wherein a thickness of the first backside contact is greater than a thickness of the second backside contact.

7. The integrated circuit device of any one of Claims 1 to 6, wherein a portion of the dam is in the backside insulating layer, and
wherein a thickness of the portion of the dam is thinner than a thickness of the first portion of the backside insulating layer.

8. The integrated circuit device of Claim 7, wherein the passive device region comprises a transistor comprising a source/drain region, and
the semiconductor layer of the passive device region extends between the second portion of the backside insulating layer and the source/drain region of the passive device region.

9. The integrated circuit device of any one of Claims 1 to 6, wherein a portion of the dam is in the backside insulating layer, and
wherein a thickness of the portion of the dam is at least a thickness of the semiconductor layer.

10. The integrated circuit device of any one of Claims 1 to 9, wherein the dam comprises a material different from the semiconductor layer.

11. A method of forming an integrated circuit device, the method comprising:
providing a substrate comprising a first portion in a first device region and a second portion in a second device region, wherein electric circuits are provided on a first surface of the substrate;
forming a dam in the substrate between the first portion and the second portion of the substrate, the dam comprising a material different from that of the substrate;
removing the first portion of the substrate;
forming a backside insulating layer on a second surface of the second portion of the substrate;
forming a first backside contact in the backside insulating layer and electrically connected to at least one of the electric circuits; and
forming a backside power distribution network structure, BSPDNS, on the first backside contact.

12. The method of Claim 11, wherein the first device region comprises a source/drain region, and the backside insulating layer is between the BSPDNS and the source/drain region of the first device region, and
wherein the method further comprises:
forming a placeholder in the first portion of the substrate, the placeholder comprising a material different from that of the substrate;
forming the backside insulating layer on the placeholder;
removing the placeholder, thereby forming a space in the backside insulating layer; and
forming the first backside contact in the space, wherein the first backside contact is electrically connected to the source/drain region of the first device region.

13. The method of claim 12, further comprising:
forming a semiconductor layer in the second portion of the substrate;
removing a portion of the backside insulating layer, thereby forming a recess in the backside insulating layer, wherein the recess exposes a portion of the semiconductor layer; and
forming a second backside contact in the recess.

14. The method of any one of Claims 11 to 13, wherein the substrate comprises an etch stop layer that extends between an upper portion and a lower portion of the substrate; and
the dam is in the upper portion of the substrate.

15. The method of any one of Claims 11 to 14, wherein the backside insulating layer extends between the dam and the BSPDNS, and
wherein the dam comprises a semiconductor material different from the substrate.
